**Europäisches Patentamt**

**European Patent Office**

**Office européen des brevets**

(11) Publication number : **0 431 835 B1**

# EUROPEAN PATENT SPECIFICATION

(45) Date of publication of patent specification :
**27.09.95 Bulletin 95/39**

(51) Int. Cl.[6] : **H01L 29/08, H01L 29/737**

(21) Application number : **90312979.9**

(22) Date of filing : **29.11.90**

(54) **Bipolar semiconductor device.**

(30) Priority : **30.11.89 JP 311548/89**
**30.11.89 JP 311550/89**
**28.02.90 JP 48320/89**
**28.02.90 JP 48321/89**

(43) Date of publication of application :
**12.06.91 Bulletin 91/24**

(45) Publication of the grant of the patent :
**27.09.95 Bulletin 95/39**

(84) Designated Contracting States :
**DE FR GB IT NL**

(56) References cited :
**US-A- 4 672 413**
**International Electron Devices Meeting,**
**Technical Digest, Dec. 4-6, 1978, Washington,**
**US, IEEE, New York, US, pp. 333-335 ; H.C. de**
**Graaff et al. : "The SIS Tunnel Emitter"**

(56) References cited :
**Proc. of the 1987 Bipolar Circuits and Technol-**
**ogy Meeting, Sept. 21-22, 1987, Minneapolis,**
**US, IEEE, New York, US, pp. 54-56 ; R. Mertens**
**et al. : "Comparison of Advanced Emitters for**
**High Speed Silicon Bipolar Transistors"**

(73) Proprietor : **CANON KABUSHIKI KAISHA**
**30-2, 3-chome, Shimomaruko,**
**Ohta-ku**
**Tokyo (JP)**

(72) Inventor : **Morishita, Masakazu, c/o Canon**
**Kabushiki Kaisha**
**30-2, 3-chome, Shimomaruko,**
**Ohta-ku**
**Tokyo (JP)**

(74) Representative : **Beresford, Keith Denis Lewis**
**et al**
**BERESFORD & Co.**
**2-5 Warwick Court**
**High Holborn**
**London WC1R 5DJ (GB)**

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

BACKGROUND OF THE INVENTION

Field of the Invention

This invention relates to a semiconductor device, more particularly to a semiconductor device of bipolar transistor structure.

Related Background Art

There have been known in the art devices having thin films through which tunnel current flows to the emitter, such as bipolar transistor (BPT) with MIS structure, heterobipolar transistor (HBT) having micro-crystal ($\mu$c) or amorphous semiconductor as the emitter, etc.

In the case of the above-mentioned BPT with MIS structure, by utilizing the difference in tunnel probability between electrons and positive holes, the positive holes from the base are impeded by the above-mentioned thin film, thereby effecting reduction of the base current.

However, the above-mentioned BPT with MIS structure of the prior art, for obtaining characteristics for effecting reduction of the above-mentioned base current, will require a necessary minimum thickness of the above-mentioned thin film. If its thickness is too thin, the inhibition ratio of positive holes will be lowered, whereby no reduction of the base current can be effected, with the result that the direct series resistance of the emitter will be increased.

Also, in the case when the difference in transmittance of positive holes and electrons is small, inhibition of positive holes cannot be accomplished. Further, although utilization of such difference in transmittance may be applicable to an npn type transistor, it is not applicable to a pnp transistor which is different in junction type.

On the other hand, in the HBT having an $\mu$cSi semiconductor emitter of the prior art, the emitter-base junction, namely the interface between the emitter

and the base is unstable, and in the low current region of base current, particularly recombination becomes prevailing, whereby the current amplification ratio $h_{FE}$ will be markedly lowered.

Also, in $\mu$c-Si of the prior art, addition of heat treatment will result in reduction of current amplification ratio $h_{FE}$ even at, for example, 450 °C. Such reduction may be considered to be caused particularly by lowering in band gap and elimination of H (hydrogen) contained in $\mu$c-Si, etc. because of increased particle size of $\mu$c-Si.

SUMMARY OF THE INVENTION

The present invention has been accomplished in view of the above-mentioned problems as described above, and is intended to provide a semiconductor device which can inhibit increase of base current in low current region, can maintain high current amplification ratio over a broad region of collector current, and has been made applicable to junction transistors of all the types of npn and pnp.

In accordance with the present invention there is provided a semiconductor device comprising:

a semiconductor device comprising:

a collector region of first conductivity type;

a base region of second conductivity type;

an emitter region of the first conductivity type of thickness not greater than a diffusion length of a minority carrier injected from said base region;

a thin film provided on said emitter region for flowing a tunnel current; and

a semiconductor material layer laminated on said thin film and having an energy band gap at least broader than that of the material of said emitter region.

In the semiconductor device described above, there is provided an emitter region, a thin film and a semiconductor material layer laminated on the thin film. This basic structure of semiconductor device is known from International Electron Devices Meeting, Technical Digest, December 4 to 6, 1978 IEEE New York, pp 333-335 entitled "The SIS Tunnel Emitter" by H.C. De Graaff et al in which there is described a silicon nbn transistor having an $n^+$ monocrystalline silicon emitter region, an insulating layer and an $n^+$ polysilicon semiconductor material laminated on the insulating layer. The insulating layer has a thickness of 2 to 6 nm and tunnel current flows therethrough. No distinction is drawn between the energy band gaps of the emitter region and the semiconductor material layer and from figure 3 of this reference these energy band gaps would appear to be the same.

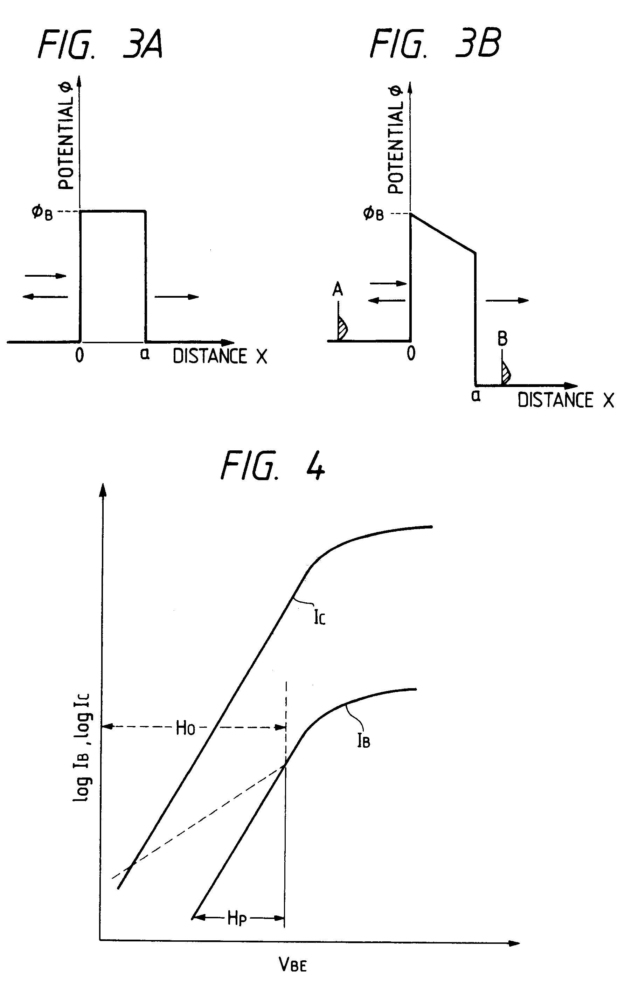

United States Patent US 4672413 (Gardener) also discloses a bipolar transistor having a tunnel barrier of thin film insulating material between and a heavily doped n-type emitter and a p-type base region or alternatively between an n-type emitter region and a region of the same conductivity type as the emitter region. Similarly, no distinction is drawn between the energy band gaps of the material each side of the thin film and from figure 4 of the drawings these band gaps appear to be the same.

## BRIEF DESCRIPTION OF THE DRAWINGS

Fig. 1 is a schematic sectional view of a semiconductor device for illustration of the first embodiment of the present invention;

Fig. 2 is a diagram showing the potential along the line A-A' in Fig. 1;

Fig. 3A is an illustrative diagram showing the relationship between potential and distance for illustration of the tunnel film;

Fig. 3B is an illustrative diagram showing the relationship between potential and distance when a corresponding voltage is applied to the tunnel film;

Fig. 4 is a graph for comparison of voltage, current between a transistor according to the present invention and a transistor of the prior art;

Fig. 5 is a graph showing the relationship between the impurity concentration and the life of positive holes in the emitter region;

Fig. 6A is an illustrative diagram showing energy levels at a junction of n-type Si and n-type SiC:

Fig. 6B is an illustrative diagram showing energy levels at junctions of n-type Si, n-type SiC and n-type Si;

Fig. 6C is an illustrative diagram showing energy levels of n-type Si, n-type SiC thin film and n-type Si;

Fig. 7 is a schematic sectional view illustrating the second embodiment of the present invention; and

Fig. 8 is a schematic sectional view illustrating the third embodiment of the present invention.

Fig. 9 is a circuit diagram showing an embodiment of an electronic device including a semiconductor device embodying the present invention.

## Detailed Description of the Preferred Embodiments

The semiconductor device to be described is equipped with a collector region of a first conductivity type, a base region of a second conductivity type and an emitter region of the first conductivity type, and has a thin film provided on said emitter region through which tunnel current can flow, and a semiconductor material layer which is provided on said thin film and has a forbidden band gap broader than the above-mentioned emitter region. In this device the emitter region is of a thickness not greater than the diffusion length of minority carriers injected from the base region.

The semiconductor device desirably should have the above-mentioned thin film set at a thickness which gives rise to tunnel phenomenon with respect to both electrons and positive holes.

It is preferable that the semiconductor device should have a semiconductor layer, having a forbidden band gap narrower than that of the semiconductor material layer, laminated on said semiconductor material layer.

In addition, the semiconductor device can be used in an electronic device as a photoelectric converting element.

As described above, a thin film which causes both tunnel phenomena of positive holes and electrons to occur is formed on an $N^+$ emitter region, and further by preparation of a semiconductor material layer with broader forbidden band region than the emitter region on said thin film, in the case of the npn type BPT, inflow of positive holes can be impeded by said semiconductor material layer to effect reduction of the base current.

The film thickness of the thin film prepared on the emitter region desirably should be 5 nm (50 Å) or less. The film thickness of the above-mentioned thin film preferably should be as thin as possible. As the thickness is thinner, the direct series resistance is lowered, whereby positive holes will also undergo tunnel phenomenon similarly as electrons.

Also, if an emitter-base junction is prepared in single crystal, increase of the base current in a low current region can be suppressed.

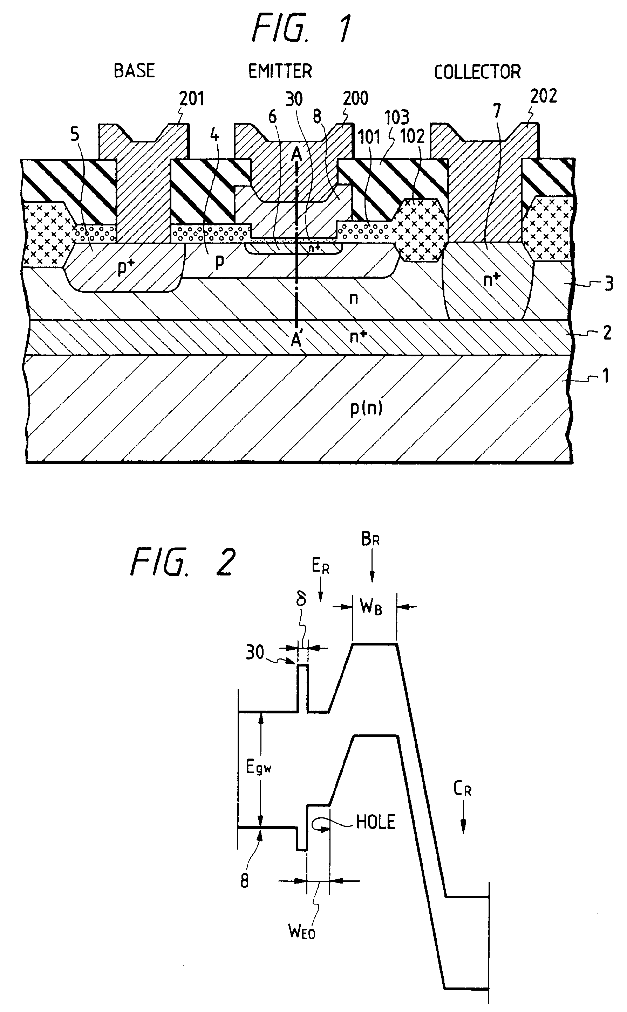

The first preferred embodiment of the present invention is described now with reference to Fig. 1.

In the same Figure, 1 is a silicon substrate, and said substrate 1 is an n-type substrate which has been made n-type by doping of an impurity of an element of the group V of the periodic table such as phosphorus (P), arsenic (As), antimony (Sb), etc. or a p-type substrate which has been made p-type by doping of an impurity of an element of the group III of the periodic table such as boron (B), aluminium (Al), gallium (Ga), etc.

2 is an $n^+$ embedded region, and said $n^+$ embedded region has an impurity concentration such as of P, As, Sb, etc. of $10^{16}$ to $10^{20}$ [$cm^{-3}$].

3 is an n-type region as a part of the collector region, and said n-type region 3 is a region with a low impurity concentration (e.g. about $10^{13}$ to $5 \times 10^{17}$ [cm$^{-3}$]) formed by epitaxial technique, etc.

4 is a p-type region as the base region, and said p-type region 4 is a region containing an impurity such as B, Al, Ga, etc. at an impurity concentration of $10^{15}$ to $10^{20}$ [cm$^{-3}$].

5 is a P$^+$ region, and said P$^+$ region is a region containing an impurity such as B, Al, Ga, etc. at an impurity concentration of $10^{17}$ to $10^{20}$ [cm$^{-3}$] for lowering the base resistance.

6 is a n$^+$ emitter region.

7 is a n$^+$ region, and said n$^+$ region is provided for connecting the collector electrode 202 as described below to the above-mentioned embedded region 2 so as to lower the collector resistance.

8 is a semiconductor material layer, and said semiconductor material layer 8 comprises a material having broader gap of forbidden band as compared with the material of the above-mentioned emitter region 6 so as to impede the carriers injected from the base.

30 is a thin film, and said thin film 30 comprises a thin insulating material for flowing tunnel current.

101, 102, 103 are insulating films for separation between the electrodes, elements and wirings.

200, 201, and 202 are respectively emitter electrode, base electrode and collector electrode, and the respective electrodes 200, 201 and 202 are formed of metals, silicides, etc.

Preferably the above-mentioned thin film 30 should be made extremely thin, thereby permitting both electrons and positive holes to pass therethrough (not required to impede positive holes) and reducing the emitter resistance. The above-mentioned semiconductor material layer 8 comprises a material having broad forbidden band gap, and therefore impedes minority carriers injected from the base.

Fig. 2 shows the potential diagram at the cross-section A-A' in Fig. 1.

In the same Figure, $W_B$ shows the neutral region width of the base, $W_{EO}$ the neutral region width of the emitter, and $\delta$ the thickness of the thin film 30.

The greatest characteristic function of the above-mentioned thin film 30 is to separate the above-mentioned semiconductor material layer 8 from the single crystal in the emitter region 6, thereby effecting stabilization of said semiconductor material layer 8. More specifically, when the respective regions of emitter-base-collector use Si as the substrate, if a microcrystal ($\mu$c) forbidden band Si is chosen as the semiconductor layer 8 having broad forbidden band gap, when the above-mentioned thin film 30 is not formed, due to the heat treatment after formation of said $\mu$c-Si, an epitaxial growth starts from a monocrystal substrate a crystal form at a boundary is changed, whereby lowering of the current amplification ratio $h_{FE}$ is brought about. Further, partial epitaxial growth occurs. Variation in BPT property becomes significantly greater. By provision of the thin film 30, the element characteristics can be prevented from the influences due to change that in the crystal form of $\mu$c does not occur.

On the other hand, if a polycrystal of GaAs is chosen as the semiconductor material layer 8, because Ga or As is an impurity for Si which is the substrate material, its electroconductive characteristics will be changed. Shortly speaking, the thin film 30 can impede diffusion of the impurity, or even if it cannot impede, can reduce such diffusion.

As the above-mentioned semiconductor material layer 8, SiC, etc. can be also employed. As the crystal form of the semiconductor material layer 8, all of amorphous, polycrystalline and single crystal forms are applicable.

As the thin film 30 causing the tunnel phenomenon to occur, chemically stable materials are preferable, such as $SiO_2$, $Si_3N_4$, $Al_2O_3$, etc. The material is not limited to insulating materials, but semiconductors such as SiC, etc. also may be employed.

The crystal form may be amorphous, polycrystal, or mono-crystal, while, for the purpose of dividing the areas 8 and 6, amorphous would be more preferable. However, in choosing these materials, materials which may have deleterious effects on the substrate material should be avoided as a matter of course.

Next, the above-mentioned tunnel effect is to be described. When electrons from the semiconductor material layer 8 pass through the emitter region $E_R$ shown in Fig. 2, it can be described by referring to a model of barrier potential as shown in Fig. 3. Here, when $\phi_B$ is defined as the barrier height and $\underline{a}$ as the barrier width, the tunnel probability $T_t$ of the electron with an energy E having an effective mass $m*$ becomes as follows from the Schrödinger's equation:

$$T_t = \left[ 1 + \frac{\phi_B{}^2 \mathrm{Sinh}^2\,\beta a}{4E(\phi_B - E)} \right]^{-1} \quad (1)$$

wherein

$$\beta = \left[ \frac{2m*\,(\phi_B - E)}{\hbar^2} \right]^{\frac{1}{2}} \quad (2)$$

Here, if $\phi_B \gg E$, $\beta a \gg 1$, $T_t$ becomes as follows:

$$T_t = 16 \frac{E}{\phi_B} \exp(-2\beta a) \quad (3)$$

wherein

$$\beta \simeq (2m^* \phi_B)^{1/2} / \hbar \quad (4)$$

Next, when a voltage is applied, the potential becomes inclined in the thin film 30 as shown in Fig. 3B, whereby the tunnel probability $T_t$ is increased.

Here, the total tunnel current $I_{et}$ may be speculated as follows:

$$I_{et} = A \int_x^\infty F_{c1}(E) n_{c1}(E) T_t (1 - F_{c2}(E)) n_{c2}(E) dE \quad \ldots (5)$$

In the above formula, A is a constant, $T_t$ the tunnel probability in the above formula (1), $F_{c1}$ $F_{c2}$ are Fermi-Dirac distribution functions of the above-mentioned semiconductor material layer 8 and the emitter region $E_R$, and $n_{c1}$, $n_{c2}$ represent the state densities of the conduction bands of said both materials.

In the foregoing formula (5) when $\phi_B >> E$, the item concerned with the thickness of the thin film 30 comes outside of the object to be integrated, becoming as follows:

$$I_{et} \propto \exp(-2\beta a) \quad (6)$$

whereby it can be understood that an expotential functional effect occurs in the thickness of the thin film 30. Thus, the thickness contributes most greatly to the electron tunnel current $I_{et}$.

In the foregoing formula (5), another important item is the following item:

$$F_{c1}(1 - F_{c2}) \quad (7)$$

wherein $F_{c1}$ denotes a probability of existence of an electron at the side of A, $(1-F_{c2})$ denotes a probability of inexistence of an electron at the side of B, and a product thereof would greatly effect on an electron transition, but for increasing the item of this product, a voltage corresponding to about kT or higher may be applied on the thin film 30, and, for example, it may be about 0.025 V at room temperature.

In the case of BPT, the voltage drop in the above-mentioned thin film 30 is about the above-mentioned voltage value and, as shown in Fig. 3B, during voltage application, the existing probability is shifted in energy as shown by A, B, whereby in the energy band having the same energy as the energy of electrons on the side of the semiconductor material layer 8 (the left side in Fig. 3B), there exists no electron on the emitter side (right side in Fig. 3B) and transition of electrons can be readily effected. Also, by voltage application on the thin film 30, the barrier height is slightly reduced.

In the present invention, as shown in Fig. 2, both the thickness $W_{EO}$ of the emitter region $E_R$ and the concentration N are important factors for reducing the base current.

Usually, the above-mentioned thin film 30 has a thickness of 5nm (50Å) or less, which is comparatively smaller as compared with the thickness of the $n^+$ emitter region 6, and the distance $W_E$ from the emitter-base junction portion to the semiconductor material layer 8 is represented by:

$$W_E \simeq W_{EO} + \delta \quad (8)$$

and becomes substantially equal to $W_{EO}$.

A minimum limit of a thickness of the film 30 is desirably 0.2-0.3 nm (2-3Å). Further preferably, in case of $SiO_2$, the film 30 is a mono-atom layer with uniformly distributed 0.

On the other hand, another important factor in the present invention, namely impedance of minority carriers injected from the base, is effected at the interface between the semiconductor material layer 8 and the thin film 30. Of course, since the tunnel probability for electrons and positive holes in the thin film 30 is greater for electrons, the reduction effect of the base current by positive holes is obtained as the overlapping action of the both.

Next, the constituents of the current of the above-mentioned BPT are to be described.

The collector current Jc is approximately represented by the following formula (9):

$$J_c = \frac{q \cdot D_n \cdot n_i^2}{N_B \cdot W_B} \{\exp(\frac{V_{BE}}{kT}) - 1\} \quad (9)$$

wherein the diffusion distance is made longer than the base width. $N_B$ is the base concentration, $W_B$ the base width, $D_n$ the diffusion coefficient of electrons, $n_i$ the intrinsic carrier density and $V_{BE}$ the base-emitter applied voltage.

On the other hand, the base current comprises the recombination current $J_{Brec}$ in the base and the diffusion current $J_{Bdiff}$ of the positive holes injected from the base into the emitter.

Here, the recombination current $J_{Brec}$ is represented by:

$$J_{Brec} = \frac{q \cdot D_n \cdot n_i 2 \cdot W_B}{2N_B \cdot L_n^2} \{exp \left(\frac{V_{BE}}{kT}\right) - 1\} \quad (10)$$

wherein $L_n$ is the diffusion distance of electrons.

In the homo-junction form BPT of the prior art, $J_{Bdiff}$ is the main component, and no high current gain can be obtained.

The diffusion current $J_{Bdiff1}$ in the homo-BPT of the prior art when the diffusion length $L_p$ of the positive holes is smaller than the emitter thickness WE (case 1) ($L_P << W_E$) is represented by:

$$J_{Bdiff1} - \frac{q \cdot D_P}{L_P} \cdot \frac{n_i 2}{N_E} \{exp \left(\frac{V_{BE}}{kT}\right) - 1\} \quad (11)$$

On the other hand, when shallowing of the emitter junction accompanied by higher integration is effected, the relationship becomes $L_p >> W_E$ (case 2), whereby the diffusion current $J_{Bdiff2}$ is represented by:

$$J_{Bdiff2} = \frac{q \cdot D_P}{W_E} \cdot \frac{n_i^2}{N_E} \{exp \left(\frac{V_{BE}}{kT}\right) - 1\} \quad (12)$$

Therefore, the diffusion current becomes further greater, whereby the current amplification ratio $h_{FE}$ of BPT is reduced.

In the case of the present invention, when the recombination speed at the hetero-interface is made a negligible value, the diffusion current $J_{Bdiff3}$ is represented by the following formula (13) ($L_p >> W_E$):

$$J_{Bdiff3} \frac{q D_P \cdot W_E}{L_P^2} \cdot \frac{n_i^2}{N_E} \{exp \left(\frac{V_{BE}}{kT}\right) - 1\} \quad (13)$$

In BPT of the present invention, in the above-mentioned case 1, the diffusion current $J_{Bdiff}$ becomes $W_E/L_B$-fold relative to the homo-junction form BPT of the prior art.

Further, relative the above-mentioned case 2, the diffusion current $J_{Bdiff}$ becomes $(W_E/L_p)^2$-fold.

Thus, in the present embodiment, the diffusion current $J_{Bdiff}$ can be dramatically reduced. In other words, the current amplification ratio $h_{FE}$ can be dramatically increased.

In the MIS structure BPT of the prior art, there exists no diffusion $J_{Bdiff}$ because $W_E=0$, but other current components exist.

Fig. 4 is a graph showing schematically the current-voltage characteristics of the transistor, the axis of abscissa showing the applied voltage between the base-emitter, the axis of ordinate the base current $I_B$ and the collector current $I_c$ represented in logarithmic values. In the BPT of the present invention, the collector current $I_c$ and the base current $I_B$ become substantially parallel to each other, and also in the low current region (Hp), the current amplification ratio $h_{FE}$ ($=I_C/I_B$) becomes a constant value, but in the MIS structure BPT of the prior art, excessive current flows in the low current region ($H_o$).

The base current in BPT's embodying the present invention is primarily the recombination current represented by the above formula (10), and the maximum value $h_{FEmax}$ of the current amplification ratio in this case is as follows:

$$h_{FEmax} = 2 (L_n/W_B)^2 \quad (14)$$

and the upper limit of $h_{FE}$ is determined only by the base conditions. In the embodiment of the present invention, $h_{FE}$ becomes 10000 or higher.

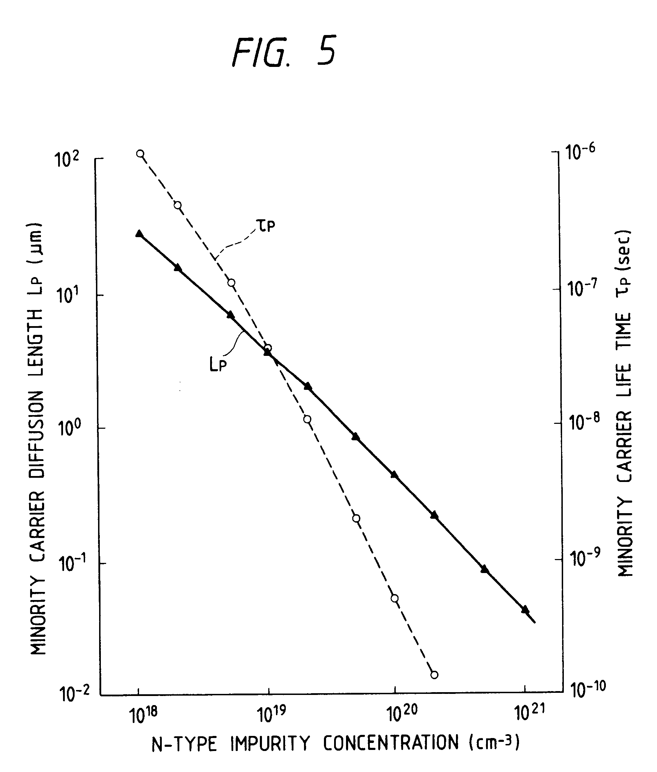

Fig. 5 shows the relationships between the impurity concentration in the above-mentioned $n^+$ emitter region 6 and the diffusion distance $L_P$ of the minority carriers (positive holes) and the life $\tau_P$ of said minority carriers (positive holed). According to a condition determined by the formula (13), it is preferable that the emitter depth should be made at least about 1/5 of the diffusion distance of positive holes.

Next, the preparation process of the semiconductor device shown in Fig. 1 is to be described.

(1) On a substrate 1 of a predetermined conduction type (p-type or n-type) is formed an $n^+$ embedded region 2 with an impurity concentration of $10^{15}$ to $10^{19}$ [cm$^{-3}$] by ion injection (or impurity duffusion, etc.) of As, Sb, P, etc.

(2) By epitaxial technique, etc. an n-type region 3 with an impurity concentration of $10^{14}$ to $10^{17}$ [cm$^{-3}$] is formed.

(3) An $n^+$ region 7 for reducing the resistance of the collector [with an impurity concentration of $10^{17}$ to $10^{20}$ [cm$^{-3}$]) is formed.

(4) An insulation film 102 for element separation is prepared by the selective oxidation method or the CVD method, etc.

(5) In the active region, a $p^+$ region 5 and a p region 4 which is the base region are formed by the ion injection method, etc.

(6) After opening of an emitter contact on the insulation film 101, an $n^+$ emitter region doped with As, Sb, P, etc. (impurity concentration 5 x $10^{17}$ to 5 x $10^{20}$ [cm$^{-3}$]) is formed by the ion injection method or the thermal diffusion method.

(7) A thin film 30 is prepared by oxidation at lower temperature of 500 °C to 650 [°C] or by thermal oxidation by rapid thermal acceleration (RTA).

(8) After deposition of a microcrystal Si doped to $n^+$ according to the plasma CVD method on the above-mentioned thin film 30, it is subjected to patterning.

(9) An insulation film 103 is deposited, which is annealed and then subjected to opening of contact.

(10) an Al-Si (1 %) which becomes the electrode 200 is subjected to spurttering, followed by patterning of the Al-Si.

(11) After alloy formation of the Al-Si electrode, a passivation film is formed.

According to the procedure as described above, an MIS structure BPT is completed.

As the above-mentioned thin film 30, a silicon oxide film is the optimum, because it can be easily formed at low temperature, but an insulation film such as silicon nitride film, alumina film, etc. may be also employed.

Also, by use of SiC, etc., a structure which becomes the tunnel type barrier may be formed. Explanation will made with regard to an example of mono-crystal. For example, SiC, as compared with Si has a conduction band energy difference $\triangle Ev \simeq 0.53$ [eV], a valence electron band difference $\triangle Ec \simeq 0.55$ [eV] and a band gap $Eg \simeq 2.2$ [eV], and when both SiC and Si are junctioned stepwise in n-type, it becomes to have a structure different from the semiconductor/insulator junction.

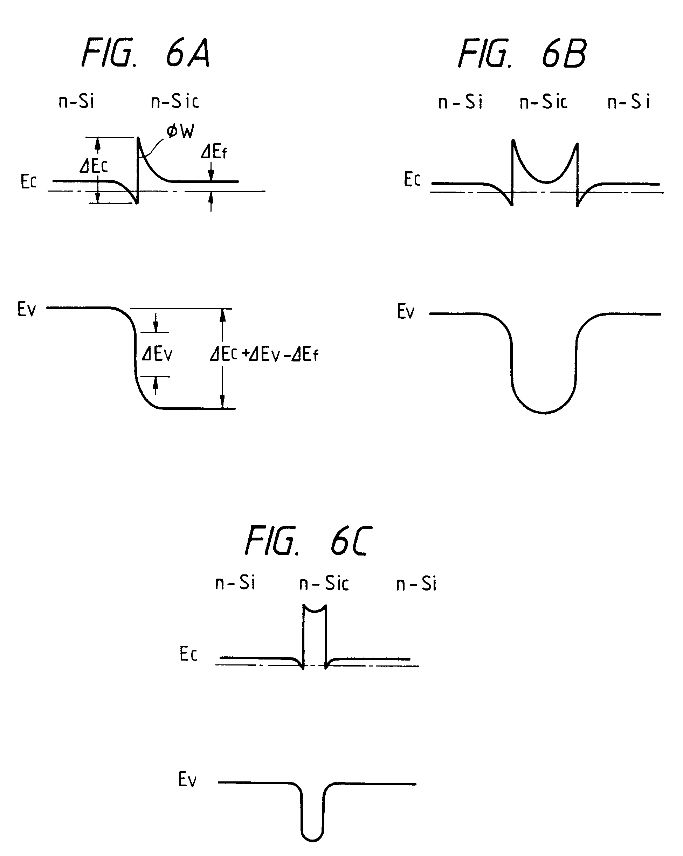

Figs. 6A, 6B, 6C show a band structure of hetero-junction mutually of the same conduction type (n-type in this case), namely the isotype.

Fig. 6A shows the junction of the n-type Si and the n-type SiC, $\triangle Ec$, $\triangle Ev$ appearing respectively above and below, and a barrier $\phi_W$ called notch being formed on the conduction band side, while on the valence electron side, an energy difference of the following is created:

$$\triangle Ec \ + \ \triangle Ev \ - \ \triangle Ef.$$

On the other hand, by junction of the n-type Si, the n-type SiC and the n-type Si, the energy level becomes as shown in Fig. 6B.

Further, by forming SiC into a thin film, the SiC will be depleted to become similar to an insulation material, whereby the potential distribution becomes as shown in Fig. 6C.

With the structure shown in Fig. 6C, the electron current can be made greater. In Fig. 6A to Fig. 6C, an example by use of SiC is shown, but it will be apparent that other materials with broad forbidden band gap can be also employed.

The crystal structure of the tunnel film may be mono-crystal, polycrystal, or amorphous.

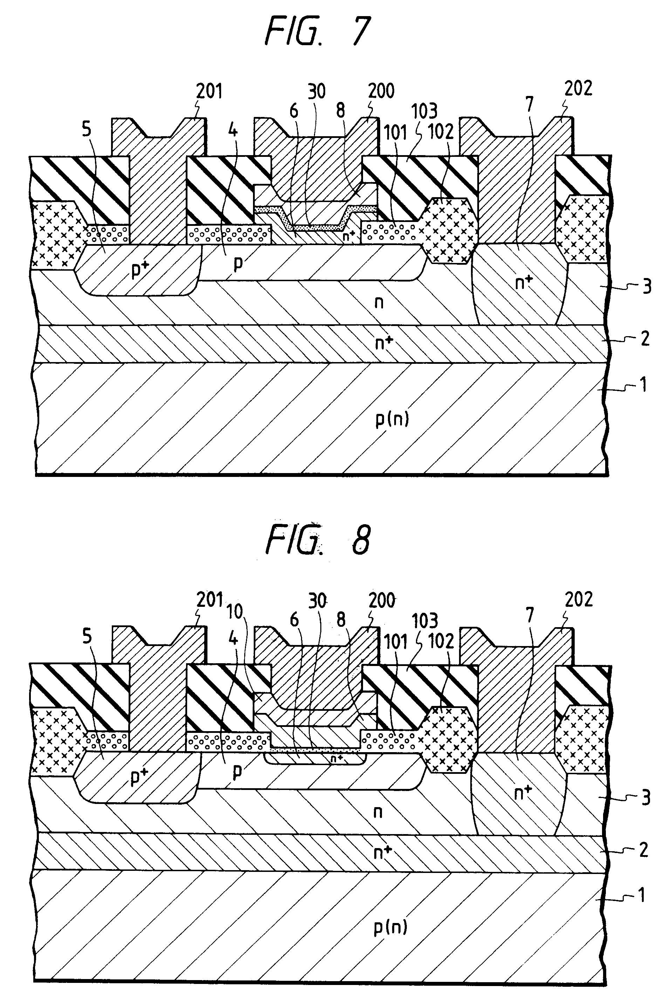

Next, by referring to Fig. 7, a preferable second embodiment of the semiconductor device of the present invention is to be described. In this embodiment, an emitter region 6 is formed by epitaxial growth on the base region (p-type region 4), and on the emitter region 6 is formed a thin film 30 for the tunnel. By making such structure, it becomes that $W_E=0$ in the above-mentioned formula (13), whereby it becomes possible to achieve a current amplification ratio which is approximate to the above-mentioned maximum amplification ratio $h_{FEmax.}$

Next, by referring to Fig. 8, a third preferred embodiment of the semiconductor device of the present invention is to be described. This embodiment is different from the above-described first embodiment in that a semiconductor material layer 8 is formed on the thin film 30 and a semiconductor layer 10 of a material with narrower forbidden band gap than said semiconductor material layer 8 is further formed on said semiconductor material layer 8. With such construction, in this embodiment, ohmic resistance between the emitter and the metal is improved. If the semiconductor material layer 8 is SiC, the semiconductor layer 10 preferably should be selected as Si, while if the semiconductor material layer 8 is Si, the semiconductor layer 10 preferably should be selected as Ge, etc.

The conduction type of the semiconductor layer 10 is the same as that of the semiconductor material layer 8.

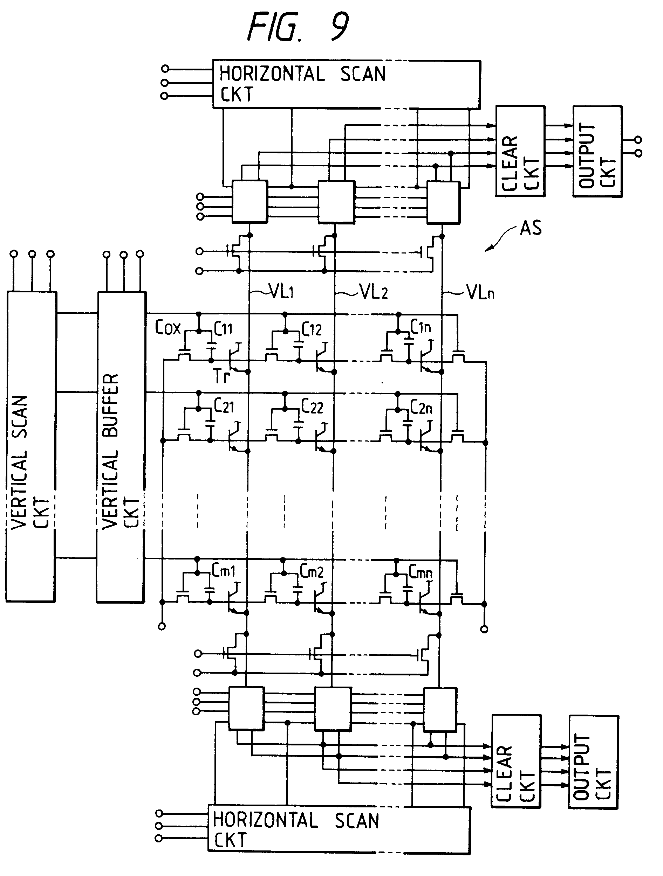

Fig. 9 is a circuit example showing an example of the electronic device as an application example of the semiconductor device according to the above-mentioned embodiment. It shows the case when the BPT shown in the above-described embodiment 1 is used in the solid image pick-up device disclosed by the present Applicant in Japanese Patent Application No. 62-321423.

More specifically, in Fig. 9, the transistor Tr constituting the sensor cells $C_{11}$, $C_{12}$, ... $C_{mn}$ of the area sensor AS employs the MIS type BPT shown in the above-described first embodiment.

When the area sensor AS shown in Fig. 9 is used as a colour camera, the actuation of reading optical informations of the same photoelectric converting device for plural times is performed.

As described above, according to the present invention, since $C_{tot}=10$ [pF], $C_v=2.5$ [pF] in the collector region of the first conduction type and the base region of the second conduction type, for example, for making the non-destruction degree 0.90 or higher, $h_{FE}$ is required to be 2250 or higher. For obtaining sufficient non-destruction degree, it may be estimated that $h_{FE}$ is required to be 2000 or higher.

In contrast, in the prior art, for example, in homo-junction BPT, $h_{FE}$ is about 1000, and hence no sufficient

7

non-destruction degree can be obtained, while in the present invention, excellent non-destruction degree can be obtained because $h_{FE}$ can be made sufficiently great in the semiconductor device of the present invention.

Further, desirably, the non-destruction degree should be 0.98 or higher. In this case, $h_{FE}$ is required to be about 10000 or more, but it is difficult to obtain such a value in the homo-junction BPT or the prior art.

In the embodiment shown in Fig. 9, an area sensor was exemplified, but the present invention is also applicable to a line sensor as a matter of course.

Also, the transistor in Fig. 9 can also apply the second and third embodiments as described above.

Also in this case, excellent non-destructive reading can be done.

In this case, for reading for plural times from the same element, the ratio of the electrical output during the first reading to that during the second reading and thereafter is a problem, and correction is required when the value of this ratio has become smaller.

When the ratio of the first reading output to the second is defined as the non-destruction degree, the non-destruction degree is represented by the following formula:

Non-destruction degree=$(c_{tot} \times h_{FE})/(C_{tot} \times h_{FE} + C_v)$.

Here, $C_{tot}$ indicates the total capacity of the transistor Tr shown in Fig. 9 connected to the base, which is determined by the base-collector capacity $C_{bc}$ anc $C_{ox}$. $C_v$ is the floating capacity of the reading line shown by $VL_1 ... VL_n$. However, $C_{ox}$ may not sometimes exist depending on the circuit system.

Therefore, the above-mentioned non-destruction degree can be easily improved by increasing the current amplification ratio $h_{FE}$. Thus, by making $h_{FE}$ greater, the non-destruction degree can be made greater.

Here, the constitution is made to have an area sensor region corresponding to HD (High Division), namely corresponding to high vision, an emitter region of the first conduction type, a thin film provided on said emitter region capable of flowing tunnel current and a semiconductor material layer laminated on said thin film and having a broad forbidden band gap than at least the above-mentioned emitter region, and therefore it is possible to suppress increase of the base current at the fine current region of the collector current, whereby markedly high current amplification ratio can be maintained over a wide region of the collector current and dependency of the current amplification ratio on the collector current can be avoided. Due to the intervening presence of the thin film, there becomes no interference between the semiconductor material layer having a broad forbidden band gap and the emitter region, whereby stabilization of said semiconductor material can be effected.

Also, by setting the above-described thin film at a thickness which causes tunnel phenomena for both of electrons and positive holes to occur, reduction of the emitter resistance can be effected.

Since the emitter region has a thickness thinner than the diffusion length of minority carriers injected from the above-mentioned base region, the current amplification ratio is dramatically increased.

In addition, by laminating a semiconductor layer having a narrower forbidden band gap on the above-mentioned semiconductor material layer with broad forbidden band gap as compared with its forbidden band gap, the ohmic resistance between the emitter region and the metal can be further reduced.

By use of the semiconductor device of the present invention as a photoelectric converting element, the current amplification ratio of the transistor as said photoelectric converting element can be improved and also dependency of the current amplification ratio on the collector current can be eliminated, whereby the linearity of the output relative to the optical input can be maintained to provide an electronic device with little dark current and high signal/noise ratio (S/N ratio).

## Claims

1. A semiconductor device comprising:
   a collector region (2,3,7) of first conductivity type;
   a base region (4,5) of second conductivity type;
   an emitter region (6) of the first conductivity type of thickness not greater than a diffusion length of a minority carrier injected from said base region (4,5);
   a thin film (30) provided on said emitter region (6) for flowing a tunnel current; and
   a semiconductor material layer (8) laminated on said thin film (30) and having an energy band gap at least broader than that of the material of said emitter region (6).

2. A semiconductor device according to claim 1, wherein
   the thickness of said thin film (30) is such that the tunnel effect occurs for both types of carrier, i.e. electron and hole.

3. A semiconductor device according to claim 1, wherein

another semiconductor layer (10) having relatively narrower band gap is laminated on said semiconductor material layer (8).

4. A semiconductor device according to claim 1, wherein
said semiconductor device is used as a photoelectric conversion device.

5. A semiconductor device according to claim 1, wherein
the thickness of said thin film (30) is not greater than 5 nm (50Å).

6. A semiconductor device according to claim 1, wherein
said emitter region (6) is formed from silicon mono-crystal.

7. A semiconductor device according to claim 6, wherein
said semiconductor material layer (8) is formed from a material selected from micro-crystalline silicon, GaAs, and SiC.

8. A semiconductor device according to claim 1, wherein
said semiconductor material layer (8) is amorphous, polycrystal, or monocrystal.

9. A semiconductor device according to claim 1, wherein
said thin film (30) is formed from $SiO_2$, $Si_3N_4$, $Al_2O_3$, or SiC.


**Patentansprüche**

1. Halbleitervorrichtung mit:
einem Kollektorbereich (2, 3, 7) eines ersten Leitfähigkeitstyps,
einem Basisbereich (4, 5) eines zweiten Leitfähigkeitstyps,
einem Emitterbereich (6) des ersten Leitfähigkeitstyps mit einer Dicke, die nicht größer als eine Diffusionslänge eines von dem Basisbereich (4, 5) injizierten Minoritäts-Ladungsträgers ist,
einem Dünnfilm (30), der auf dem Emitterbereich (6) zum Fließenlassen eines Tunnelstroms vorgesehen ist, und
einer Halbleitermaterial-Schicht (8), die auf den Dünnfilm (30) geschichtet ist und eine Energieband-Lücke aufweist, die zumindest breiter als die des Materials des Emitterbereichs (6) ist.

2. Halbleitervorrichtung nach Anspruch 1, wobei die Dicke des Dünnfilms (30) dergestalt ist, daß der Tunneleffekt für beide Arten von Ladungsträgern, das heißt Elektronen und Löcher, auftritt.

3. Halbleitervorrichtung nach Anspruch 1, wobei eine andere Halbleiterschicht (10) mit einer vergleichsweise schmaleren Bandlücke aud der Halbleitermaterial-Schicht (8) geschichtet ist.

4. Halbleitervorrichtung nach Anspruch 1, wobei die Halbleitervorrichtung als photoelektrische Wandlervorrichtung verwendet wird.

5. Halbleitervorrichtung nach Anspruch 1, wobei die Dicke des Dünnfilms (30) nicht größer als 5 nm (50 Å) ist.

6. Halbleitervorrichtung nach Anspruch 1, wobei der Emitterbereich (6) aus einem Silizium-Einkristall gebildet ist.

7. Halbleitervorrichtung nach Anspruch 6, wobei die Halbleitermaterial-Schicht (8) aus einem Material gebildet ist, das aus mikrokristallinem Silizium, GaAs und SiC ausgewählt wird.

8. Halbleitervorrichtung nach Anspruch 1, wobei die Halbleitermaterial-Schicht (8) amorph, polykristallin oder einkristallin ist.

9. Halbleitervorrichtung nach Anspruch 1, wobei der Dünnfilm (30) aus $SiO_2$, $Si_3N_4$, $Al_2O_3$ oder SiC gebildet ist.

**Revendications**

1. Un dispositif à semiconducteurs comprenant :
   une région de collecteur (2, 3, 7) d'un premier type de conductivité;
   une région de base (4, 5) d'un second type de conductivité;
   une région d'émetteur (6) du premier type de conductivité, ayant une épaisseur qui n'est pas supérieure à une longueur de diffusion d'un porteur minoritaire injecté à partir de la région de base (4, 5);
   une pellicule mince (30) formée sur la région d'émetteur (6) pour faire circuler un courant tunnel; et
   une couche de matériau semiconducteur (8) formée sur la pellicule mince (30) et ayant une bande d'énergie interdite au moins supérieure à celle du matériau de la région d'émetteur (6).

2. Un dispositif à semiconducteurs selon la revendication 1, dans lequel
   l'épaisseur de la pellicule mince (30) est telle que l'effet tunnel se produit pour les deux types de porteurs, c'est-à-dire les électrons et les trous.

3. Un dispositif à semiconducteurs selon la revendication 1, dans lequel
   une autre couche de semiconducteur (10) ayant une bande interdite relativement plus étroite est formée sur la couche de matériau semiconducteur précitée (8).

4. Un dispositif à semiconducteurs selon la revendication 1, dans lequel
   ce dispositif à semiconducteurs est utilisé en dispositif de conversion photoélectrique.

5. Un dispositif à semiconducteurs selon la revendication 1, dans lequel
   l'épaisseur de la pellicule mince (30) n'est pas supérieure à 5 nm (50 Å).

6. Un dispositif à semiconducteurs selon la revendication 1, dans lequel
   la région d'émetteur (6) est formée à partir d'un monocristal de silicium.

7. Un dispositif à semiconducteurs selon la revendication 6, dans lequel
   la couche de matériau semiconducteur (8) est formée à partir d'un matériau sélectionné parmi le silicium microcristallin, le GaAs et le SiC.

8. Un dispositif à semiconducteurs selon la revendication 1, dans lequel
   la couche de matériau semiconducteur (8) est amorphe, polycristalline ou monocristalline.

9. Un dispositif à semiconducteurs selon la revendication 1, dans lequel
   la pellicule mince (30) est formée à partir de $SiO_2$, $Si_3N_4$, $Al_2O_3$ ou SiC.

## FIG. 1

BASE EMITTER COLLECTOR

## FIG. 2

# FIG. 3A

# FIG. 3B

# FIG. 4

FIG. 5

## FIG. 6A

n-Si        n-Sic

## FIG. 6B

n-Si    n-Sic    n-Si

## FIG. 6C

n-Si    n-Sic    n-Si

EP 0 431 835 B1

FIG. 7

FIG. 8

15

## FIG. 9